# FASCICULE DE BREVET EUROPEEN

(11) **EP 2 729 972 B1**
(45) Date de publication et mention de la délivrance du brevet: **06.04.2016**
(21) Numéro de dépôt: 12731006.8
(22) Date de dépôt: 04.07.2012
(51) Int. Cl.: H01L 51/44, H01L 51/52

(54) **DISPOSITIF DE TYPE PHOTODIODE CONTENANT UNE CAPACITE POUR LA RÉGULATION DU COURANT D'OBSCURITE OU DE FUITE**
FOTODIODENVORRICHTUNG MIT EINEM KONDENSATOR ZUR STEUERUNG VON DUNKELSTROM ODER LECKSTROM
PHOTODIODE DEVICE CONTAINING A CAPACITOR FOR CONTROLLING DARK CURRENT OR LEAKAGE CURRENT

(30) Priorité: 04.07.2011 FR 1156026
(43) Date de publication de la demande: 14.05.2014
(73) Titulaire: Commissariat à l'Énergie Atomique et aux Énergies Alternatives, 75015 Paris (FR); ISORG, 38000 Grenoble (FR)
(72) Inventeur: BENWADIH, Mohamed, F-94500 Champigny Sur Marne (FR)
(74) Mandataire: Ahner, Philippe
(86) Numéro de dépôt international: PCT/EP2012/063038
(87) Numéro de publication internationale: WO 2013/004746

(56) Documents cités:
- EP-A1- 1 484 632
- EP-A1- 2 023 435
- WO-A1-2005/106573
- WO-A1-2008/001756
- WO-A1-2011/070951
- DE-A1-102006 052 608
- JP-A- 2000 231 985
- US-A1- 2006 292 955
- US-A1- 2010 018 581

## Description

### DOMAINE TECHNIQUE ET ART ANTÉRIEUR

La présente invention concerne le domaine des photo-détecteurs organiques (Organic Photo detectors, OPD) ou des photo-émetteurs organiques (OLED) et traite plus particulièrement du problème de l'optimisation du rendement d'une photodiode de type détecteur ou émetteur.

Le document US 2010/0207112 traite du courant d'obscurité (I_{dark}) d'un OPD.

Un OPD capte des rayons lumineux (ou photons) et les convertit en courant électrique. Un photon arrivant sur une couche organique, appelée couche active, va être dissocié en une paire d'électron/trou. Cette paire électron/trou va être séparée via l'application d'un champ électrique externe et les électrons seront collectés par l'électrode positive et les trous par l'électrode négative. Pour obtenir des performances optimales, il faut pouvoir absorber et convertir un maximum de photons en paires électrons/trous et collecter un maximum d'électrons et de trous aux électrodes.

L'architecture la plus communément utilisée est l'empilement vertical de couches organiques et/ou non organiques.

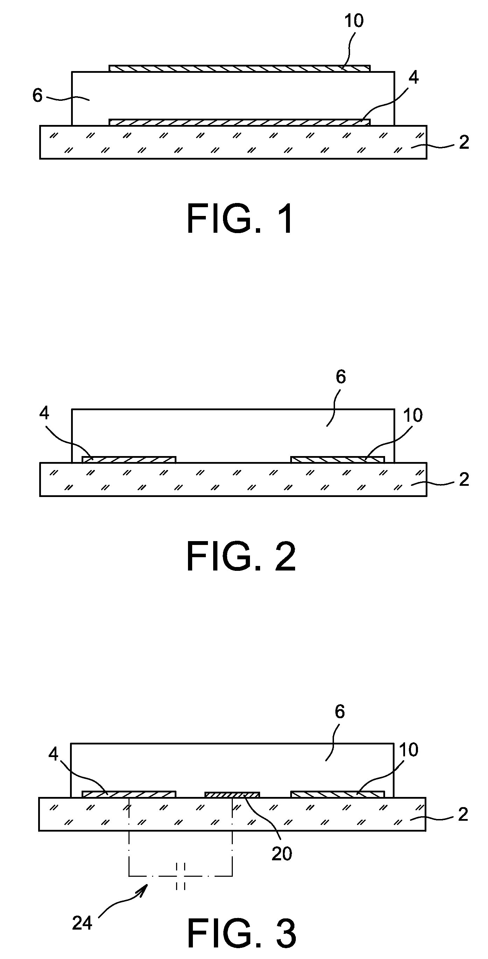

La figure 1 montre une telle structure d'OPD :
- Sur un substrat 2 de verre, repose une couche 4 transparente d'ITO, faisant office de première électrode, par exemple d'anode ; elle a été réalisée par exemple par pulvérisation, dans un bâti de dépôt et elle sert d'électrode inférieure,
- ensuite, une couche d'injection d'électrons (Electron injection layer, EIL, par exemple en PDOT : PSS) est déposée par exemple par dépôt sous vide,
- un mélange de polymère de type n et p (par exemple en PBCM :P3HT) en, est appelé couche active 6 (ou hétérojonction volumique) ; celle-ci a par exemple été déposée par des techniques de dépôt telles que le spin-coating, le spray-coating...,
- une couche d'injection de trous (Hole injection layer, HIL, par exemple en ZnO); elle a par exemple été déposée par technique dite « spin-coating ».
- Enfin, une couche métallique 10 sert d'électrode supérieure (ou cathode); elle a par exemple été déposée par une technique de dépôt sous vide, ou même par une technique d'impression.

Dans ce type d'architecture, une des deux électrodes au moins est transparente afin de permettre la détection de la lumière (anode ou cathode).

Il existe aussi une autre structure, dite architecture horizontale, illustrée en figure 2.

Les électrodes anodes 4 et cathodes 10 sont alors sur le même niveau, en surface du substrat 2 et la couche active 6 est disposée sur, et entre, ces deux dernières.

Quille que soit la structure envisagée, la couche active 6 peut être constituée de « petites molécules » (par exemple des molécules de TIPS (triisopropylsilyléthynyl) pour le type p, mélangées à du diimidepéryl-déne pour le type n), déposées par évaporation sous vide, ou est en un matériau polymère déposé par voie humide (spin-coating, doctor-blading, jet d'encre...),

D'une manière gérérale, une photodiode est un composant semi-conducteur (n + p) pour détecter un rayonnement du domaine optique et le transformer en signal électrique et, à l'inverse, créer des photons lorsqu'elle est soumise à une tension électrique. Une photodiode peut par exemple comporter une hétérojonction pn ou bien une double hétérojonction pin.

D10: « Effects of Different Materais Used for Internal Floating Electrode on the Photovoltaic Properties of Tandem Type Organic Solar Cell », de Triyana et al., Japanese Journal of Applied Physics vol.43, n°4B, 2004, p.2352-2356 présente une photodiode organique comportant : une anode, une cathode, une couche active, une troisième électrode disposée dans la couche active entre la première électrode et la deuxième électrode et qui n'est pas en contact avec ladite première électrode ou avec ladite deuxième électrode, la troisième électrode formant avec la première électrode ou avec la deuxième électrode des armatures d'une capacité.

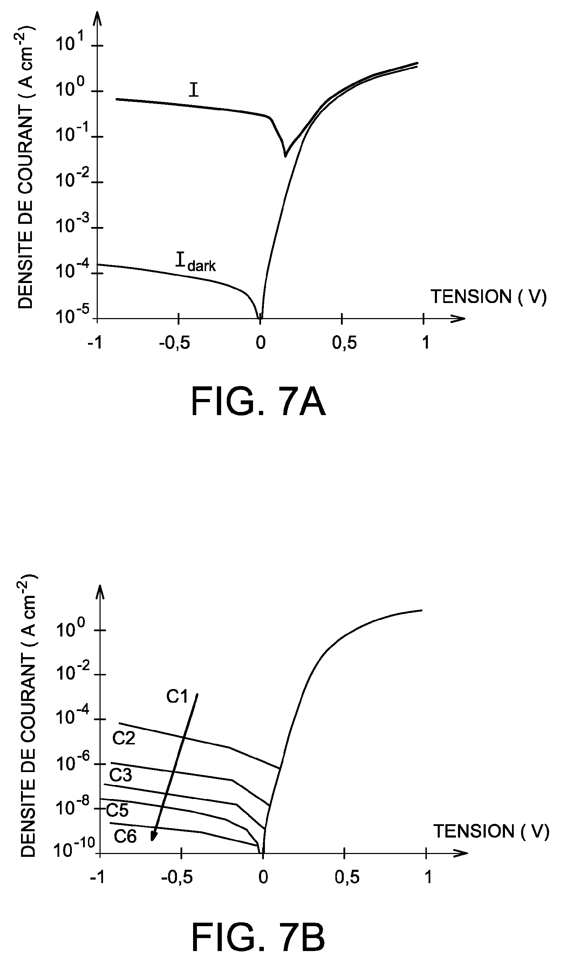

On appelle courant d'obscurité le courant qui traverse la photodiode, provoquant un signal non nul, même en l'absence de lumière à l'entrée. La figure 7A représente l'évolution, en fonction de la tension appliquée entre les électrodes 4, 10, d'une part du courant détecté I et, d'autre part, du courant d'obscurité I_{dark}. Ce dernier est généré par des processus physiques autres que l'absorption des photons à détecter. La performance d'une photodiode se caractérise par un courant (I), sous illumination, le plus élevé possible et un I_{dark} (ou courant d'obscurité) le plus faible possible.

La différence entre le courant d'obscurité et le courant sous illumination permet une détection de la lumière. Pour optimiser la finesse de cette détection on cherche à minimiser le courant d'obscurité (sans illumination).

De façon similaire, lorsque le photoémetteur n'est pas en fonctionnement, une lumière parasite peut éclairer le dispositif et créer des charges qui seront indésirables, formant un courant de fuite.

Il se pose le problème de trouver de nouveaux moyens permettant de réduire le courant d'obscurité dans un photodétecteur de type OPD ou le courant de fuite dans un photoémetteur de type OLED.

### EXPOSÉ DE L'INVENTION

On décrit dans la présente demande un nouveau type de photodiode organique, comportant une première électrode, une couche active, une deuxième électrode, et au moins une troisième électrode, formant une capacité avec l'une des premières et deuxième électrode ou avec une 4^{ème} électrode.

Autrement dit, la capacité peut être formée entre la première électrode et la troisième électrode, ou entre la deuxième électrode et la troisième électrode, ou bien entre une quatrième électrode, disctincte de la première et de la seconde électrode, et la troisième électrode.

Il est également décrit une photodiode organique comportant une première électrode formant une anode, une couche active, une deuxième électrode formant une cathode, et au moins une troisième électrode formant une capacité avec une autre électrode correspondant à la première électrode ou à la deuxième électrode ou à une quatrième électrode disctincte de la première et de la deuxième électrode. La capacité ainsi formée permet de piéger au moins une partie d'un courant d'obscurité (I_{dark}) ou d'un courant de fuite (I_{off}) de la photodiode. La photodiode organique comporte en outre des moyens pour ajuster une tension aux bornes de ladite capacité en fonction du courant d'obscurité (par exemple lorsque la photodiode forme un photodétecteur) ou du courant de fuite (I_{off}) (par exemple lorsque la photodiode forme un photoémetteur) que l'on souhaite piéger.

On crée donc une capacité additionnelle au dispositif, à l'aide d'une électrode supplémentaire, la troisième électrode, ce qui permet de piéger au moins une partie des charges indésirables du courant d'obscurité ou du courant de fuite. Cette électrode supplémentaire joue le rôle de l'une des armatures de la capacité additionnelle. L'autre armature est soit l'une des électrodes déjà existantes soit une autre électrode supplémentaire.

Lorsque la photodiode est en mode non actif, la capacité additionnelle, comportant la troisième électrode, est mise sous tension afin de bloquer les charges mobiles du courant d'obscurité ou du courant de fuite, présentes dans la couche active et de les empêcher d'atteindre le circuit électrique de la photodiode.

On décrit donc une photodiode, comprenant deux électrodes et une couche active formant un circuit électrique de détection, caractérisé en ce qu'elle comprend au moins une 3^{ème} électrode dans la couche active constituant l'une des armatures d'une capacité additionnelle. Celle-ci est soit hors circuit de détection, soit en parallèle à ce circuit.

En fonction du niveau de signal à détecter on peut ajuster la valeur de la capacité additionnelle, ce qui permet de moduler le courant I_{dark} (courant d'obscurité) ou I_{off} (= Courant de fuite).

Différents modes de réalisation peuvent être réalisés; ainsi, un dispositif selon l'invention peut comporter :
- un substrat sur lequel sont disposées la première électrode et la deuxième électrode, la troisième électrode étant elle aussi disposée sur ce substrat (autrement dit les trois électrodes peuvent être en contact avec le substrat sans se toucher mutuellement),
- un substrat sur lequel est disposée la première électrode, par exemple au contact dudit substrat, la deuxième électrode étant disposée sur la couche active, et au moins la troisième électrode étant disposée dans la couche active, entre la première électrode et la deuxième électrode,
- une quatrième électrode, disposée dans la couche active, entre la première électrode et la deuxième électrode, cette quatrième électrode formant, avec la troisième électrode, la capacité pour piéger une partie de courant d'obscurité ou du courant de fuite.

Encore en variante, la troisième électrode peut former, avec la première électrode, ou avec la deuxième électrode, la capacité pour piéger une partie de courant d'obscurité ou du courant de fuite.

Quel que soit le mode de réalisation envisagé, dans un tel dispositif, au moins la troisième électrode peut être encapsulée dans une portion de matériau diélectrique, dont la constante diélectrique est de préférence comprise entre 2 et 4. Ce matériau diélectrique peut être par exemple du polyvinyle phénol ou du polyméthacrylate ou du polystyrène ou de la silice ou de l'alumine.

### BRÈVE DESCRIPTION DES DESSINS

- La figure 1 représente une structure connue d'OPD ou d'OLED.
- La figure 2 représente une autre structure connue d'OPD ou d'OLED, dite horizontale.
- La figure 3 représente une nouvelle structure d'OPD ou d'OLED.
- Les figures 4A et 4B représentent le focntionnement d'une nouvelle structure d'OPD ou d'OLED, de type horizontale.
- Les figures 5A et 5B représentent le fonctionnement d'une nouvelle structure d'OPD ou d'OLED, de type verticale.
- La figure 6 représente une configuration dans laquelle une capacité avec diélectrique est insérée dans la couche active.
- Les figures 7A et 7B représentent, respectivement, l'évolution du signal mesuré et du courant d'obscurité (ou de fuite) dans un photodétecteur de type OPD (d'un photoémetteur de type OLED), de structure connue (figure 7A) et l'évolution du courant d'obscurité (ou de fuite) fonction de la valeur de la capacité additionnelle dans un photodiode selon l'invention.

### EXPOSÉ DÉTAILLÉ DE MODES DE RÉALISATION PARTICULIERS

Les exemples ci-dessous sont décrits dans le cas d'un photodétecteur, mais ils peuvent être aisément transposés au cas d'un photoémetteur.

La figure 3 représente une nouvelle structure d'OPD, comportant, une première électrode 4, une deuxième électrode 10 toutes deux disposées sur un substrat 2. Ce dernier peut être rigide (en verre) ou flexible (par exemple en polymère ou en métal).

Une couche active 6 est disposée entre les deux électrodes 4, 10.

Cette couche active 6 est par exemple en un mélange de polymère de type n et p (par exemple en PBCM :P3HT); celle-ci a par exemple été déposée par des techniques de dépôt telles que le spin-coating, le spray-coating...

Ce dispositif peut en outre comporter une couche d'injection d'électrons (Electron injection layer, EIL, par exemple en PDOT :PSS), déposée par exemple par dépôt sous vide et/ou une couche d'injection de trous (Hole injection layer, HIL, par exemple en ZnO); elle a par exemple été déposée par technique dite « spin-coating ».

On désigne :
- par PDOT :PSS, le polyéthylène dioxythiophène : polystyrène sulfonate,
- par PBCM, le Phénylbrétirique acide ester,
- par P3HT, le Poly3-héxylthiophène,

L'une des électrodes, destinée à former l'anode 4, peut être en un matériau transparent, par exemple en ITO mais peut aussi être en nanotubes de C, ou en matériau polymère conducteur. Elle est par exemple déposée par pulvérisation dans un bâti de dépôt.

L'autre électrode, destinée à former la cathode 10, peut être déposée par évaporation sous vide. Elle est par exemple en aluminium ou en un mélange de fluorure de lithium et d'aluminium.

Une troisième électrode 20 est également disposée sur le substrat 2, entre les deux électrodes 4, 10. Cette troisième électrode forme, avec la première électrode 4, une capacité symbolisée sur la figure 3 par la référence 24. La composition et/ou la technique de formation, de cette troisième électrode peut/peuvent être identique(s) ou similaire(s) à celle de l'une des autres électrodes.

Bien que cela ne soit pas représenté sur les figures (car ce sont des vues en coupe), des connexions relient chacune des électrodes à des plots permettant leur alimentation électrique à l'aide de moyens d'alimentation.

Pour contrôler un courant d'obscurité, on alimente cette capacité 24 en appliquant une tension aux bornes des deux électrodes 4, 20. Cette capacité bloque la circulation d'au moins une partie du courant d'obscurité, entre l'anode 4 et la cathode 10 de l'OPD, en piégeant les charges de la couche active 6.

On peut adapter la valeur de la tension appliquée aux bornes de cette capacité 24, en fonction du niveau de courant d'obscurité afin de le bloquer plus ou moins efficacement (ceci n'est pas contradictoire avec l'indication, plus loin, selon laquelle les tensions appliquées aux bornes de cette capacité jouent un rôle secondaire, car ces tensions sont très faibles, de sorte qu'elles ne perturbent pas le fonctionnement sous illumination).

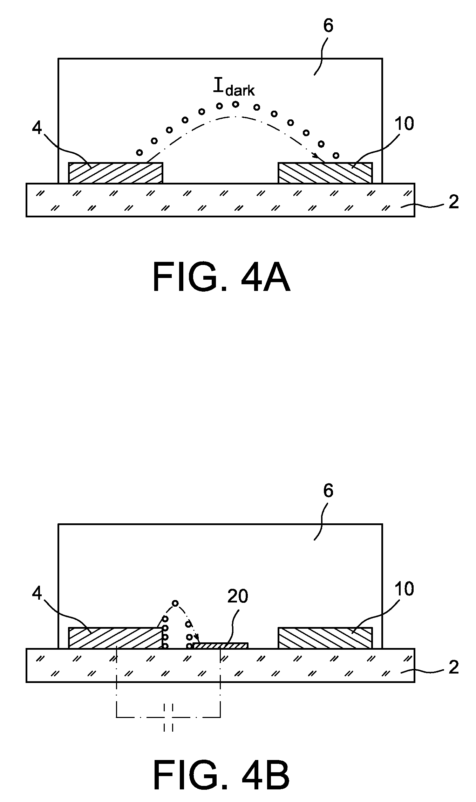

Pour illustrer le fonctionnement d'un tel dispositif, on a représenté schématiquement, en figure 4A une structure OPD, de type connu, sans la troisième électrode 20 décrite ci-dessus. Le courant d'obscurité I_{dark} circule, de l'anode 4 à la cathode 10.

La figure 4B représente schématiquement une structure OPD, avec la troisième électrode 20, formant la structure décrite ci-dessus. Le courant d'obscurité I_{dark} circule, de l'anode 4 à la troisième électrode 20, et il n'atteint pas la cathode 10. Lorsqu'un rayonnement incident est capté par le photodétecteur, la composante du courant d'obscurité dans le signal mesuré est réduite par rapport au cas de la figure 4A.

L'architecture représentée en figure 3 est de type horizontal.

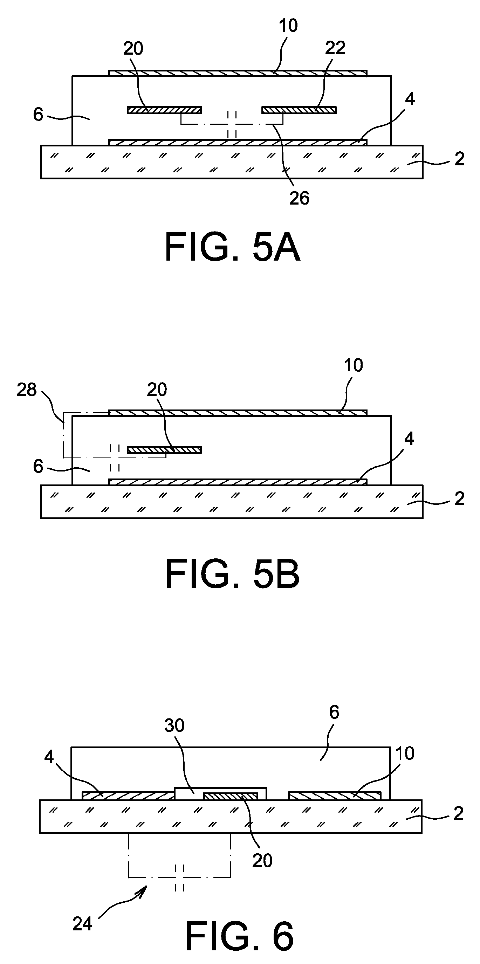

Mais on peut également mettre en oeuvre une architecture verticale, comme représenté schématiquement en figures 5A et 5B.

Les 2 électrodes 4, 10, sont disposés de part et d'autre de la couche active 6, l'ensemble reposant sur le substrat 2. Les matériaux déjà indiqués ci-dessus pour les électrodes et pour la couche active peuvent être utilisés également ici.

Dans la structure de la figure 5A, une troisième électrode 20 et une quatrième électrode 22 sont disposées dans la couche active 6, entre la première électrode 4 et la deuxième électrode 10 et sensiblement parallèlement à ces dernières. Ces deux électrodes 20, 22 sont en outre disposés sensiblement au même niveau dans la couche active 6, c'est-à-dire qu'il y a sensiblement la même distance entre chacune d'elles et chacune des 2 autres électrodes 4, 10. Là encore, les électrodes sont connectées à des pistes et/ou des plots électriques, qui permettent de les mettre sous tension à l'aide de moyens d'alimentation en tension.

Ce sont ces deux électrodes internes 20, 22 de la couche active 6 qui vont alors former une capacité 26, laquelle va permettre de capter au moins une partie du courant d'obscurité I_{dark} lors du fonctionnement du dispositif en temps que photo détecteur.

Dans la structure de la figure 5B, une troisième électrode 20 est disposée dans la couche active 6, entre la première électrode 4 et la deuxième électrode 10 et sensiblement parallèlement à ces dernières. Là encore, les électrodes sont connectées à des pistes et/ou des plots électriques, qui permettent de les mettre sous tension à l'aide de moyens d'alimentation en tension.

Ce sont alors les 2 électrodes 10, 20 (ou 4 et 20) qui vont former une capacité 28, laquelle va permettre de capter au moins une partie du courant d'obscurité I_{dark} lors du fonctionnement du dispositif en temps que photo détecteur.

Dans les exemples qui ont été décrits ci-dessus, c'est le matériau de la couche active 6 qui forme le matériau de la capacité 24, 26 au 28, entre les deux armatures 4, 20 ou 10, 20 ou 20, 22 de celle-ci.

Dans une variante de la structure de type horizontal, représentée en figure 6, la troisième électrode 20 est encapsulée dans une couche diélectrique 30, elle-même enrobée par la couche active 6.

On obtient le même effet de captation du courant d'obscurité que ci-dessus mais, dans ce cas, le matériau diélectrique 30 permet d'adapter la constante diélectrique ε de la capacité, 22 afin d'améliorer la récolte des charges dans la couches actives.

Par exemple :
- si on met une couche de matériau diélectrique 30 d'épaisseur e = 50 nm avec une constante diélectrique ε = 2, la capacité sera faible et attirera seulement quelques charges,
- si on met une couche de matériau diélectrique 30 d'épaisseur e'= 50 nm avec une constante diélectrique ε' = 20, la quantité de charges piégées par la capacité sera plus grande que dans le cas précédent et l'efficacité du système sera aussi améliorée.

On choisit de préférence un matériau diélectrique 30 avec une constante diélectrique ε comprise entre 2 et 10. De préférence encore, on choisit un matériau ayant une bonne affinité chimique avec la couche active 6, permettant d'éviter des problèmes de mouillabilité au moment du dépôt.

Par exemple, on peut utiliser, en tant que matériau diélectrique 30, du PVP (polyvlnylphenol), avec ε = 4 à 6, ou du PMMA (polymethacrylate), avec ε = 2, 8 à 4,6, ou polystyrène, avec ε =3, ou encore de la silice, avec ε = 4 ou de l'alumine, avec ε = 8.

D'une manière générale, dans une structure telle que décrite ci-dessus, la capacité formée par l'une au moins des électrodes supplémentaires 20,22 joue un rôle de frein à la conduction.

En fonction de la valeur de cette capacité, on peut réduire ou accroître le niveau et la valeur du courant d'obscurité. Ceci se révèle très intéressant pour ajuster et obtenir un seuil de détection voulu.

Par exemple, on peut utiliser des valeurs croissantes de la capacité additionnelle 24, 26, 28 (par exemple en prenant des capacités de surfaces croissantes ou de permittivité ε croissante ou en appliquant des tensions croissantes) et moduler le courant résiduel d'obscurité en conséquence.

Ainsi, on a représenté, en figure 7B, l'évolution du courant d'obscurité, en fonction de la tension, pour diverses capacités C₁ - C₆, la capacité Ci (i= 2 - 6) étant plus importante que la capacité Cᵢ₋₁. (par exemple : C₁ = 1 pF, C₂ = 2 pF ; C₃ = 5 pF ; C₄ = 10 pF ; C₅ = 15 pF ; C₆ = 20 pF). On constate que le courant d'obscurité diminue avec l'accroissement de la valeur de la capacité.

En comparaison (figure 7A), le dispositif de type connu, sans électrode supplémentaire, présente, pour une tension donnée, un unique courant d'obscurité qui n'est pas réglable.

Les dimensions des armatures de la capacité 24, 26, 28 donnent la valeur de la capacité C voulue ; en effet C = εS/d (d = épaisseur, ε = permittivité du matériau formant diélectrique entre les électrodes et S surface des armatures).

Dans une structure telle que celle de la figure 3, 5B ou 6, l'armature supplémentaire 20 est de préférence placée juste à coté d'une des électrodes 4, 10 (l'électrode 4 sur les figures 3 et 6 ; l'électrode 10 sur la figure 5B) afin de couper la conduction entre les électrodes 4, 10. Les dimensions de l'électrode 20 peuvent varier ; celle-ci peut avoir par exemple une longueur, mesurée dans un plan parallèle à la surface du substrat 2, d'une centaine de µm (ou par exemple comprise entre 50 µm et 500 µm) et une largeur, mesurée dans le même plan parallèle à la surface du substrat 2, comprise entre quelques micromètres et quelques dizaines de micromètres, par exemple comprise entre 1 µm et 50 µm, par exemple encore égale à, ou voisine de, 10 µm. On choisira ces dimensions de manière à ce que l'électrode 20 puisse créer, avec l'électrode 4 ou 10, une capacité C suffisante. Typiquement, on peut utiliser une valeur de capacité C de 1 pF à 50 pF. La troisième électrode 20 (et/ou la quatrième électrode 22) peut donc avoir une surface d'au moins 50 µm². Avantageusement, les électrodes sont sous forme de doigts, de façon à présenter une surface la plus large possible, ce qui permet d'éviter les perturbations lors de l'illumination ou l'émission de photons. Leur épaisseur sera la plus faible possible ; par exemple, on prendra une épaisseur comprise entre 10 nm et 30 nm, notamment pour de l'or.

Chacune des électrodes additionnelles 20, 22 est de préférence parallèle à, ou située dans le même plan que, l'électrode avec laquelle elle va former la capacité additionnelle 24, 26 au 28. Mais, plus généralement, leur position relative peut être quelconque, pour autant qu'elles puissent former cette capacité additionnelle.

La tension appliquée entre les deux électrodes de la capacité joue un rôle secondaire car elle est très faible par rapport aux tensions appliquées à la photodiode. On peut donc appliquer une tension externe, par exemple comprise entre 1 mV et 1 volt (±1 V) alors que la diode sera soumise à, ou délivrera, des tensions comprises entre 1 V et 10 V.

On peut utiliser plusieurs capacités additionnelles dans une même photodiode, par exemple des différents générateurs de tension, mais il est plus simple d'utiliser une seule capacité par photodiode.

## Revendications

1. Photodiode organique, comportant :
- une première électrode formant une anode (4),
- une deuxième électrode formant une cathode (10),
- une couche active (6) disposée entre ladite première électrode et ladite deuxième électrode,
- au moins une troisième électrode (20),
la troisième électrode étant disposée dans la couche active entre la première électrode et la deuxième électrode et n'étant en contact ni avec ladite première électrode ni avec ladite deuxième électrode, la troisième électrode formant avec la première électrode ou avec la deuxième électrode ou avec une quatrième électrode (24) disctincte de la première et de la deuxième électrode, des armatures d'une capacité (24, 26, 28) pour piéger au moins une partie d'un courant d'obscurité (I_{dark}) ou d'un courant de fuite (I_{off}) de la photodiode, la photodiode organique comportant en outre des moyens, dotés de pistes et/ou plots permettant de mettre sous tension la troisième électrode et/ou la quatrième électrode à l'aide de moyens d'alimentation en tension, pour appliquer une tension aux bornes de ladite capacité, en fonction du courant d'obscurité ou du courant de fuite (I_{off}).

2. Dispositif selon la revendication 1, comportant un substrat (2) sur lequel sont disposées la première électrode (4) et la deuxième électrode (10), la troisième électrode (20) étant elle aussi disposée sur ce substrat.

3. Dispositif selon la revendication 1, comportant un substrat (2) sur lequel est disposée la première électrode (4), la deuxième électrode (10) étant disposée sur la couche active (6).

4. Dispositif selon la revendication 3, la comprenant en outre une quatrième électrode (22) disposée dans la couche active (6), entre la première électrode et la deuxième électrode, cette quatrième électrode formant, avec la troisième électrode (20), la capacité (26) pour piéger une partie de courant d'obscurité ou du courant de fuite (I_{off}).

5. Dispositif selon l'une des revendications 1 à 4, le matériau entre les armatures de la capacité étant le matériau de la couche active.

6. Dispositif selon l'une des revendications 1 à 5, au moins la troisième électrode étant encapsulée dans une portion (30) de matériau diélectrique.

7. Dispositif selon la revendication 6, la constante diélectrique dudit matériau diélectrique étant supérieur à 2 et inférieur à 10.

8. Dispositif selon la revendication 6 ou 7, ledit matériau diélectrique étant du polyvinyle phénol ou du polyméthacrylate ou du polystyrène ou de la silice ou de l'alumine.

9. Dispositif selon l'une des revendications 1 à 8, ladite couche active étant un mélange de polymère de type n et p.

## Patentansprüche

1. Organische Fotodiode, umfassend:
- eine erste Elektrode, die eine Anode (4) bildet,
- eine zweite Elektrode, die eine Kathode (10) bildet,
- eine aktive Schicht (6), die zwischen der ersten Elektrode und der zweiten Elektrode angeordnet ist,
- wenigstens eine dritte Elektrode (20),
wobei die dritte Elektrode in der aktiven Schicht zwischen der ersten Elektrode und der zweiten Elektrode angeordnet und weder in Kontakt mit der ersten Elektrode noch in Kontakt mit der zweiten Elektrode ist, wobei die dritte Elektrode mit der ersten Elektrode oder mit der zweiten Elektrode oder mit einer vierten Elektrode (24), die von der ersten und der zweiten Elektrode verschieden ist, Ausrüstungsteile eines Kondensators (24, 26, 28) zum Einfangen wenigstens eines Teils eines Dunkelstroms (I_{dark}) oder eines Leckstroms (I_{off}) der Fotodiode bildet, wobei die organische Fotodiode ferner Mittel umfasst, die mit Bahnen und/oder Punkten dotiert sind, die es erlauben, die dritte Elektrode und/oder die vierte Elektrode mit Hilfe von Spannungsversorgungsmitteln unter Spannung zu setzen, um eine Spannung als Funktion des Dunkelstroms oder des Leckstroms (I_{off}) an die Anschlüsse des Kondensators anzulegen.

2. Vorrichtung nach Anspruch 1, umfassend ein Substrat (2), auf dem die erste Elektrode (4) und die zweite Elektrode (10) angeordnet sind, wobei auch die dritte Elektrode (20) auf diesem Substrat angeordnet ist.

3. Vorrichtung nach Anspruch 1, umfassend ein Substrat (2), auf dem die erste Elektrode (4) angeordnet ist, wobei die zweite Elektrode (10) auf der aktiven Schicht (6) angeordnet ist.

4. Vorrichtung nach Anspruch 3, ferner umfassend eine vierte Elektrode (22), die in der aktiven Schicht (6) zwischen der ersten Elektrode und der zweiten Elektrode angeordnet ist, wobei diese vierte Elektrode mit der dritten Elektrode (20) den Kondensator (26) zum Einfangen eines Teils des Dunkelstroms oder des Leckstroms (I_{off}) bildet.

5. Vorrichtung nach einem der Ansprüche 1 bis 4, wobei das Material zwischen den Ausrüstungsteilen des Kondensators das Material der aktiven Schicht ist.

6. Vorrichtung nach einem der Ansprüche 1 bis 5, wobei wenigstens die dritte Elektrode in einem Bereich (30) aus dielektrischem Material eingekapselt ist.

7. Vorrichtung nach Anspruch 6, wobei die Dielektrizitätskonstante des dielektrischen Materials größer als 2 und kleiner als 10 ist.

8. Vorrichtung nach Anspruch 6 oder 7, wobei das dielektrische Material Polyvinylphenol oder Polymethacrylat oder Polystyrol oder Silica oder Aluminiumoxyd ist.

9. Vorrichtung nach einem der Ansprüche 1 bis 8, wobei die aktive Schicht eine Mischung von Polymer vom Typ n und p ist.

## Claims

1. An organic photodiode, including:
- a first electrode forming an anode (4),
- a second electrode forming a cathode (10),
- an active layer (6) arranged between said first electrode and said second electrode,
- at least a third electrode (20, 22), the third electrode being arranged in the active layer between said first electrode and said second electrode and being in contact neither with the first electrode nor the second electrode, the third electrode (20) forming with the first electrode (4), or with the second electrode (10), or with the fourth electrode different from first and second electrode, capacitor (24, 26, 28) terminals to trap at least part of a dark current (I_{dark}) or a leakage current (I_{off}) of the photodiode, the organic photodiode further including means, including tracks and/or pads, for applying a voltage across said capacitor, as a function of the dark current or leakage current (I_{off}).

2. The device according to claim 1, including a substrate (2) on which the first electrode (4) and the second electrode (10) are provided, the third electrode (20) being also provided on this substrate.

3. The device according to claim 1, including a substrate (2) on which the first electrode (4) is provided, the second electrode (10) being provided on the active layer (6).

4. The device according to claim 3, further comprising a fourth electrode (22) provided in the active layer (6), between the first electrode and the second electrode, this fourth electrode forming, with the third electrode (20), the capacitor (26) to trap part of the dark current or the leakage current (I_{off}).

5. The device according to any of the claims 1 to 4, wherein the material between the capacitor terminals is the activelayer material.

6. The device according to any of the claims 1 to 5, at least the third electrode being encapsulated in a portion (30) of dielectric material.

7. The device according to claim 6, the dielectric constant of said dielectric material being higher than 2 and lower than 10.

8. The device according to claim 6 or 7, said dielectric material being polyvinyl phenol or polymethacrylate or polystyrene or silica or alumina.

9. The device according any of the claims 1 to 8, said avtive layer being a mixture of n and p-type polymer.
